# EUROPEAN PATENT SPECIFICATION

(11) **EP 4 011 704 B1**
(45) Date of publication and mention of the grant of the patent: **28.05.2025**
(21) Application number: 21201398.1
(22) Date of filing: 07.10.2021
(51) Int. Cl.: B60Q 3/233, B60Q 3/60, B60Q 3/74, B60Q 3/80, F21S 10/02, F21V 5/00, F21V 5/08, H01L 25/075, H01L 25/16, F21Y 113/13, F21Y 105/12, F21W 106/00, F21Y 107/50, F21V 5/04, H10H 20/855

(54) **A LIGHT EMITTING ASSEMBLY AND A METHOD FOR OPERATING IT**
LICHTEMITTIERENDE ANORDNUNG UND STEUERUGNSVERFAHREN
ASSEMBLAGE ÉLECTROLUMINESCENT ET PROCÉDÉ DE CONTRÔLE

(30) Priority: 11.12.2020 DK PA202070828
(43) Date of publication of application: 15.06.2022
(73) Proprietor: Harman Professional Denmark ApS, 8200 Aarhus N (DK)
(72) Inventor: Henrik Kirkeby, JEPSEN, 7830 Vinderup (DK)
(74) Representative: Kraus & Lederer PartGmbB

(56) References cited:
- EP-A1- 3 546 291
- EP-A2- 0 921 568
- WO-A1-2004/049765
- DE-A1- 102006 058 637
- DE-A1- 102017 128 896
- FR-A1- 3 047 945
- FR-A1- 3 050 701
- GB-A- 2 473 311
- JP-A- 2011 148 346
- US-A1- 2012 189 291

## Description

The documents FR 3 047 945 A1, EP 3 546 291 A1 and FR 3 050 701 A1 are disclosing known light emitting assembly for vehicle interior lighting.

The present invention relates to a light emitting assembly as defined in claim 1, a vehicle as defined in claim 11 and a method for vehicle of operating the light assembly for vehicle interior lighting as defined in claim 13.

A first aspect of the invention relates to a light emitting assembly comprising:
- a light emitting element comprising two or more individually controllable light emitters,
- a lens element positioned so as to collect and output light emitted by the light emitters, the lens element being configured to:
   ∘ emit light from a centre of a first light emitter in a first direction and
   ∘ emit light from a centre of a second light emitter in a second direction, the first and second directions having at least an angle of 1 degree between them.

In this context, the assembly may comprise only the light emitting element and the lens element. The two elements may be attached to each other, such as glued to each other. Clearly, the assembly may comprise additional elements, such as a controller, a power supply or the like. The lens element may be concave and receive in the concavity the light emitting element or at least the light emitters so as to protect the light emitters.

Light in this context will comprise visible light. Clearly, also invisible radiation, such as UV or IR radiation may be output. Some light sources invariably output also such radiation. UV radiation could be interesting, as it could induce fluorescence when impacting a fluorescent substance.

Two or more light emitters are provided. Any number of light emitters may be provided, such as 2, 3, 4, 5, 6, 7, 8, 9, 10, 12, 14, 16, 20 or more. A light emitter is an element configured to output light. A light emitter may be based on any technology, such as LED, OLED or the like. A light emitter may be configured to output a single colour or light within a fixed wavelength interval. Alternatively, a light emitter may be configured to output light with a controllable wavelength or colour.

The light emitters are controllable to output a controllable light intensity.

The light emitters are individually controllable, so that one light emitter may be controlled to increase an intensity of light output, or a colour/wavelength thereof, and the other may be controlled to increase, decrease, vary, maintain or the like of its intensity and/or wavelength/colour.

The light emitters are configured to launch light into and through the lens element.

The lens element is configured to transmit and output light from the light emitters. Naturally, a loss of light may be seen, even though it may be desired to have as little light/energy loss in the lens as possible.

The lens element may be a monolithic element or may be formed by a number of elements. The lens element may be concave to form a cavity in which the light emitters are provided. The light emitters may be provided close to a surface of the lens element in order to reduce light loss at that interface. Optical coupling may be obtained using e.g. index matching elements or liquids.

The lens element may be made of any material, such as light transmissive materials. Preferred materials may be Poly Carbonate, PMMA or glass, but any other material may be used.

The lens element is configured to:
- emit light from a centre of a first light emitter in a first direction and
- emit light from a centre of a second light emitter in a second direction, the first and second directions having at least an angle of 1 degree between them.

Thus, light from a centre of the first light emitter is emitted by the lens element. Often, light emitters are plane elements, so that a centre thereof may be identified. This centre may be a symmetric centre of the light emitter. Alternatively, the centre may be along a symmetry axis of a cone of light output by the light emitter into free air. Light along this axis will be launched into the lens and thus exit the lens as a light beam. This light beam will be emitted in a first direction defined by, among other things, an overall surface of the lens element at the interface and the direction of the light beam.

Similarly, the second light emitter emits a light beam from its centre. This second light beam also exits the lens element but now along a second direction.

The first and second light emitters may be adjacent or neighbouring, or additional light emitters may be provided between the first and second light emitters. Often, the lower the distance between two light emitters, the lower the angular difference between the light output by the lens, so the light output based on the first light emitter and an intermediate light emitter may have an angular difference below the 1 degree.

An angle of at least 1 degree exists between the first and second directions. Naturally, this angle may be larger, such as at least 2 degrees, at least 3 degrees, at least 4 degrees, at least 5 degrees, at least 6 degrees or more.

Thus, light emitted from the two light emitters will not completely overlap if launched into, through and out of the lens element.

The angle may be determined as the smallest angle between the two directions in a plane comprising both directions.

According to the invention, the light emitters are configured to emit light with different colours. In this context, a colour may be a single wavelength or a central or predominant wavelength in a wavelength interval in which the light emitter emits light.

In one embodiment, the centres of the first and second light emitters are positioned at least 200µm, such as at least 400µm apart. When a distance exists between the centres of the light emitters, the paths of the light from these centres into and through the lens element may differ, which may give rise to the above angle.

In one embodiment, the first and second light emitters are plane and provided in a common plane. Often, light emitters are provided as wafers, which have plane, light emitting surfaces. Usually, the light emitter will launch light from the plane within a cone which is symmetrical around a symmetry axis of the cone and which is perpendicular to the plane. When these planes are provided in a common plane, the light emitters emit light in the same direction. Thus, the light travelling inside the lens element may travel along displaced but parallel paths. Then, the angle between the emitted beams may be provided by the lens element at the outer surface thereof, such as, as will be described further below, different angles to the beam direction for the two beams.

In one embodiment, the first and second light emitters are plane and provided with an angle to each other of at least ½ degree. When the beams travel inside the lens element along differently angled paths, the desired minimum angle may be provided merely by this difference in introduction angle to the lens element.

In one embodiment, the lens element, at a first surface portion, at which a straight line from a centre of the first light emitter, preferably perpendicular to a plane of the emitter, intersects an outer surface of the lens element, has a first angle to a predetermined axis, and wherein the lens element, at a second surface portion, at which a straight line from a centre of the second light emitter, preferably perpendicular to a plane of the emitter, intersects an outer surface of the lens element, has a second angle to a predetermined axis, and wherein an angle of at least ½ degree, such as at least 1 degree, such as at least 2 degrees, such as at least 3 degrees, such as at least 4 degrees, such as at least 5 degrees, such as at least 10 degrees exists between the first and second angles.

Thus, two surface portions are defined by the positions where the two beams exit the lens.

These surface portions may have an angle between them. Then, even if the beams travel along parallel paths inside the lens element, an angular difference is seen in the directions of the beams launched from the lens element.

In one embodiment, a first surface portion of the lens element, at which a straight line from a centre of the first light emitter, such as perpendicular to the plane of the emitter, intersects an outer surface of the lens element, defines a first normal direction, and wherein a second surface portion of the lens element, at which a straight line from a centre of the second light emitter, such as perpendicular to the plane of the emitter, intersects an outer surface of the lens element, defines a second normal direction, wherein an angle of at least ½ degree, such as at least 1 degree, such as at least 2 degrees, such as at least 3 degrees, such as at least 4 degrees, such as at least 5 degrees, such as at least 10 degrees, exists between the first and second normal directions.

The minimum angle of 1 degree of the light output may be obtained in a number of manners. The angle, for example, will depend on the refractive index of a material of the lens. The angle difference between the surface portions may be a smallest angle in a plane comprising the directions, such as directions parallel to the surface or directions perpendicular thereto.

In fact, as radiation of different wavelengths will tend to exit a transmissive material with different angles, at least a part of the angular difference desired may be obtained by having the two light emitters emit light at different wavelengths.

In order to provide the light output by the lens element with a pleasant and varying behaviour, the lens element may be provided with light diverging elements capable of directing some of the light at different angles than defined by an overall shape of the outer surface of the lens element. The outer surface of the lens element may have small grooves or scratches which tend to deviate a portion of the light from the overall direction and shape of the beam output by the light emitter. These diverging elements may convert the otherwise usually rather homogeneous light cone output from the lens element to a more contoured and varying illumination pattern.

A second aspect of the invention relates to a vehicle comprising one or more light emitting assemblies according to the first aspect, the assemblies attached to one or more structural portion of the vehicle.

In this context, a vehicle may be a car, bus, lorry, truck, airplane, train, vessel or the like.

A structural portion in this context is an element fixed to or attached to a structure, such as a chassis, of the means of transport. Often, fixing is desired in order to ensure that the assembly does not detach from the structure. Desirably, the assemblies are attached to the structural element to provide the light in an inner compartment vehicle, such as a passenger compartment thereof.

In one embodiment, the light emitting assembly is attached to one of the group consisting of: a headrest, an armrest, a B pillar, a C pillar, a parcel shelf, or a door. The assembly emits light toward a ceiling or side portions of the vehicle in a passenger compartment thereof.

A third aspect of the invention relates to a method of operating the light emitting assembly according to the first aspect of the invention, the method comprising, during a first period of time, increasing an intensity of light output a by first light emitter and decreasing an intensity of light output by a second light emitter.

When the directions vary slightly and the intensities also vary, the light cones or patterns output by the two light emitters will seem to move slightly, even without any moving parts in the assembly.

In one embodiment, during a subsequent period of time, it may be desired to decrease the intensity of the light output by the first light emitter and increase an intensity of light output by the second or a third light emitter.

In fact, it may be desired to control the intensity of light output by the light emitters so that the combined intensity is controlled to be within a predetermined intensity interval.

Different modes or moods may be defined. A mode may be defined with a high light intensity, operation of many light emitters, high variation frequency, for example. This mode may also comprise illuminating not only the passenger area of the vehicle but also the drivers position and/or other portions of the interior of the vehicle. This mode may e.g. be used when the vehicle is not in operation, such as when the vehicle is unlocked to welcome the driver and/or passenger(s).

Other modes may be adapted to particular moods or settings. A mode may be defined for easy listening or a theatre experience where slower variations and warmer colours may be preferred. A nature mode may be defined where the colours are selected to be more green/blue/white to indicate vegetation/water/clouds. A mode may indicate water, such as waves, water falls or clouds where variation is seen in blue and white colours.

In the following, preferred embodiments of the invention will be described with reference to the drawing, wherein:
- Figure 1 illustrates two assemblies according to the invention,
- Figure 2 illustrates a light emitting element comprising four light emitters,
- Figure 3 illustrates a light emitting element comprising four light emitters,
- Figure 4 illustrates a light emitting element with more light emitters,
- Figure 5 illustrates light emitting assemblies provided in head rests of a vehicle,
- Figure 6 illustrates light output from a light emitting assembly provided in a head rest,
- Figure 7 illustrates light patterns provided in a ceiling of a vehicle and
- Figure 8 illustrates structured surfaces on a lens element.

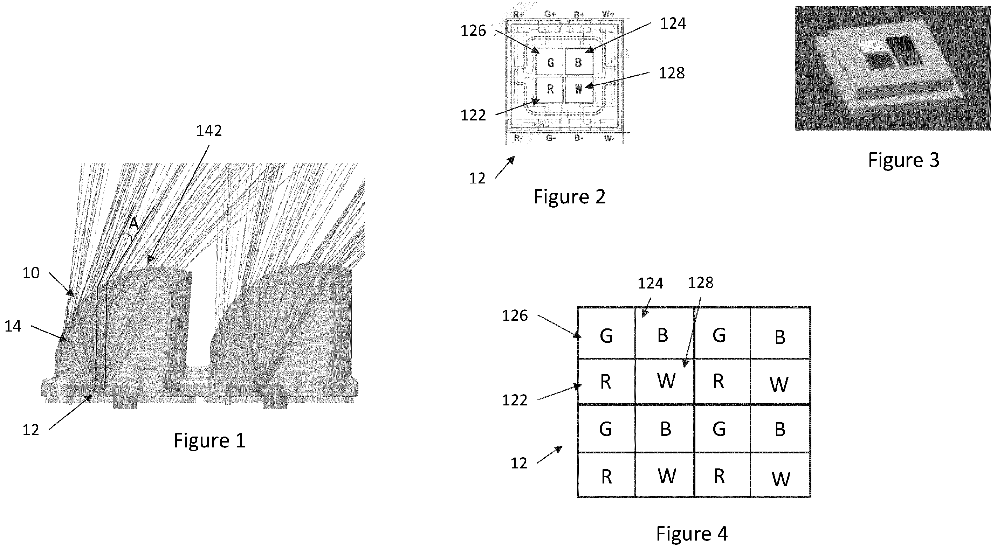

In figure 1, two assemblies 10 according to the invention are illustrated where one or more light emitters 12 emit light into the lens 14 which transmits and emits the light.

In figure 2, a light emitting element comprising a wafer comprising four light emitters, 122, 124, 126 and 128, emitting light of different wavelengths; Red, Blue, Green and White. Figure 3 illustrates a similar light emitting element.

In figure 1, two rays are traced, one to the left and from a centre of a first light emitter, such as the green light emitter 126, and one to the right from a centre of a second light emitter, such as the blue light emitter 128. Due to the displaced positions at the lower portion of the lens, the rays will travel along different paths through the lens and thus be emitted at different positions of the lens. The lens illustrated has an upper surface 142 which has different angles between the direction of the emitted beams and the surface. Thus, the beams are emitted from the lens at different angles. An angle, A, between the two beams is at least 1 degree.

In this context, a centre of a light emitter may be a centre of an emission cone of the light emitter or a light ray emitted from a centre of the light emitting die or surface and directed perpendicularly to the die or surface.

Also, in this context, the angle may be the smallest angle determined in plane comprising both directions.

Clearly, the light emitters will emit a fan or beam of light, so that the light emitted by the lens from a light emitter will also form a fan (often of a different shape) and thus illuminate a volume or area in the surroundings.

When the positions of the light emitters and the lens are configured in this manner, the resulting illumination provided by two light emitters will differ sufficiently for it to be noticeable. Then, an illumination may be arrived at which varies without any movable parts.

The different angles of the beams output from the lens may be obtained in alternative manners, such as by preparing the lens to have a different, total, refractive index along the two paths taken by the beams in the lens. In this manner, the beams may also take non-parallel paths in the lens even when the light emitters are positioned so as to output parallel beams. In addition, or alternatively, the refractive index may be varying only at an upper surface of the lens.

An alternative manner of arriving at the angle A would be to launch light from the two light emitters into the lens along different directions. Then, the light emitters could be provided with different centre angles. In this situation, any type of lens may be used.

Clearly, a light emitter may be able to output not only a varying light intensity but alternatively or additionally also a differing colour. Light emitters exist which are controllable to output controllable wavelengths. The presently preferred light emitters are not wavelength controllable in that this makes the assembly very compact, rugged and extremely cheap.

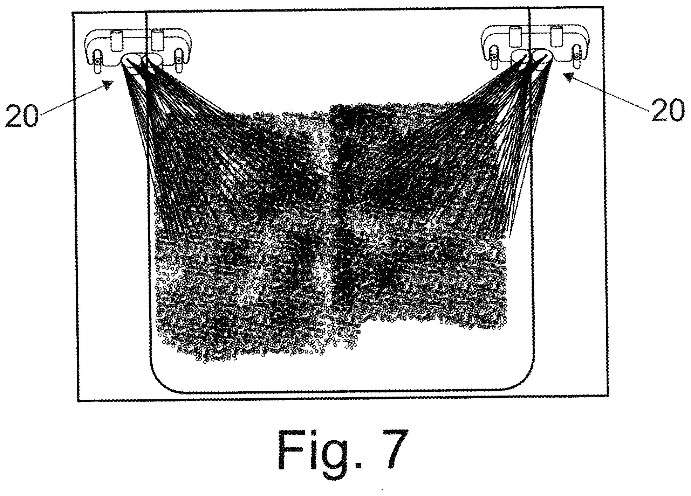

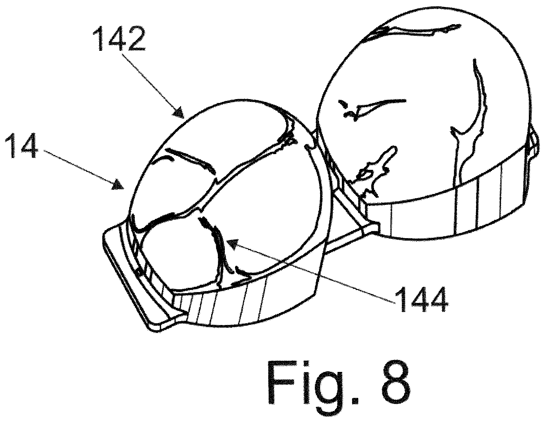

In addition, the lens may, see figure 8, have a slightly structured surface 144 or elements therein which alter the light pattern output of the light emitter from a relatively homogeneous fan of light into a more patterned light pattern (see figure 7). This may be obtained by providing grooves or scratches at or on the lens surface.

As two neighbouring light emitters may emit light fans so wide that overlapping portions of the lens and the surface may be illuminated by both, the pattern provided by the two light emitters may be similar, but displaced due to the angle A.

Then, increasing and decreasing the intensity of light emitted by a first of the light emitters and the second of the light emitters, but out of sync, will illuminate the two displaced but otherwise similar patterns with different intensities. This will give a, if the frequency of increasing and decreasing is sufficiently slow, meditative experience of the pattern changing colour and moving slightly.

Thus, the operation of the assembly may be a variation of the intensity of the light emitted by each light emitter over time. This variation may be performed in different manners. In one embodiment, the light emitters are controlled to light with a combined intensity within predetermined limits, so that the spectator is not exposed to large variations in light intensity. Thus, when one light emitter increases the intensity of light output, one or more other light emitters may decrease the intensity with which it or they emit light.

Also, this variation in intensity may be swifter or slower. A swifter variation may tend to attract more attention and thus keep the spectator awake, where a slower variation may be more relaxing and may help the spectator to fall asleep.

Then, the operation may be controllable to control the overall intensity or the frequency. A chauffeur may increase the intensity and/or the variation frequency when approaching the destination, or the person may him/herself control the operation to his/her liking.

Clearly, even though the above description has been made based on two light emitters, many more may be used. In figures 2 and 3, light emitting elements comprising four light emitters are illustrated. Preferably, the above minimum angle exists between light beams emitted by the lens and stemming from the centres of any pair of the light emitters.

Naturally, the light emitters may output light of the same colour or wavelength. It is preferred that at least some of the light emitters emit light with different colours or with different wavelength contents in order to arrive at a more differently coloured experience.

In figure 4, an even larger light emitting element is seen. In this embodiment, the structure of the light emitting element 12 of figure 2 has been duplicated into a 2x2 structure of that type. Thus, as described above, the pattern or area illuminated by a green light emitter 126 may seem slightly displaced when subsequently illuminated by the blue light emitter 124. This pattern or area may seem even further displaced when subsequently illuminated by the green light emitter to the right of the blue light emitter 124 or the blue light emitter far to the right. Thus, for some light emitters, the angular difference of the light output from the lens may be below the 1 degree, but for others, the difference exceeds the 1 degree, so that the desired displacement may be obtained. Thus, any desired displacement and thus visual effects may be obtained when more light emitters are provided which are provided over a larger area. Alternatively, a larger distance between the light emitters may, clearly, be used.

The light emitting assembly may be used in a large number of contexts, such as in a vehicle. Clearly, the light emitting assembly may be used for providing a gentle and pleasant illumination of portions of the interior of the vehicle, such as portions not visible to the driver.

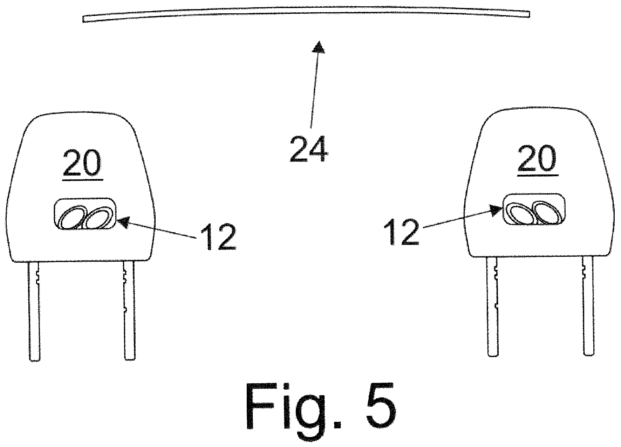

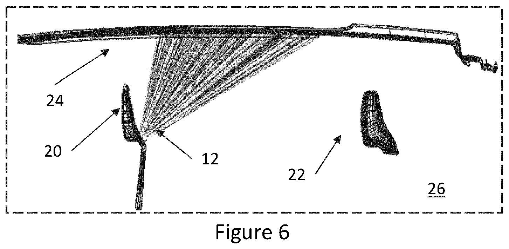

In figures 5 and 6, an embodiment is seen where sets of light emitting assemblies are provided in the headrests 20 of the front seats of a vehicle 26. The assemblies are oriented so as to illuminate portions of the ceiling or headliner 24 of the vehicle between the headrests 20 of the front seats and the headrests 22 of the back seats. When the light is emitted behind the head of the driver, the light and illuminated surface will not attract the driver's attention.

Naturally, a number of different modes may be defined. A mood may be defined or determined, such as from music played in the vehicle or a video displayed to the passenger. From this mood, such as colours of a video, the colours of the light emitters, the light intensity and/or variation frequency may be set to correspond to the mood. A mood may be related to an experience, such as being in the nature, where blue or green colours may be used, where green colours may indicate plants or vegetation, blue colours water (waves, waterfall) and white clouds. A theatre mood may call for warmer colours.

In another situation, a welcoming mode may be selected with a higher light intensity and illumination of more portions of the inner surfaces of the vehicle. This mode may be for use when the vehicle is unlocked and thus not yet in operation.

The illuminated ceiling may now entertain or please a passenger sitting in a back seat. In addition, the illumination may be used for navigating or finding things in the otherwise often dark back seat of a car driving at night.

Alternatively, the light emitting assembly, or more light emitting assemblies, may be positioned in or on the B-pillar, C-pillar or in/on the parcel shelf. The assemblies may illuminate the ceiling/headliner, the interior of the back doors or sides of the vehicle, for example.

Figure 7 illustrates light emitting assemblies provided in each of two headrests illuminating a roof/ceiling/headliner. Each light emitting assembly illuminates a separate portion of the ceiling so that each passenger may control the illumination, such as intensity, colour, on/off, frequency of shifting between the light emitters and the like.

## Claims

1. A light emitting assembly (10) for vehicle interior lighting comprising:
- a light emitting element (12) comprising two or more individually controllable light emitters (122,124,126,128),
- a controller for controlling the light emitting assembly,
- a lens element (14) positioned so as to collect and output light emitted by the light emitters (122,124,126,128), the lens element (14) being configured to:
- emit light from a centre of a first light emitter in a first direction and
- emit light from a centre of a second light emitter in a second direction, the first and second directions having at least an angle of 1 degree between them,
wherein the light emitting assembly is configured to be attached to a structural portion of a vehicle, wherein the structural portion is one of the group consisting of a headrest, an armrest, a B pillar, a C pillar, a parcel shelf, or a door,
wherein the assembly is configured to emit light toward a ceiling or side portions of the vehicle in a passenger compartment thereof,
**characterized in that**
the light emitters (122,124,126,128) are configured to emit light with different colours, wherein the emitted light of the first and second light emitters (122,124,126,128) produces a pattern in the passenger compartment of the vehicle, and by varying the intensity of the light emitters (122,124,126,128), so that, during a period of time, an intensity of light output of a first light emitter is increased and an intensity of light output of a second light emitter is decreased, the pattern is moved slightly.

2. A light emitting assembly (10) according to claim 1, wherein the centres of the first and second light emitters (122,124,126,128) are positioned at least 200 µm apart.

3. A light emitting assembly (10) according to any of the preceding claims, wherein the first and second light emitters (122,124,126,128) are plane and provided in a common plane.

4. A light emitting assembly (10) according to claim 1 or 2, wherein the first and second light emitters (122,124,126,128) are plane and provided with an angle to each other of at least ½ degree.

5. A light emitting assembly (10) according to any of the preceding claims, wherein illumination provided by the first and second emitters varies without any movable parts.

6. A light emitting assembly (10) according to any of the preceding claims, wherein the lens element (14), at a first surface portion, at which a straight line from a centre of the first light emitter, which is perpendicular to a plane of the first emitter, intersects an outer surface of the lens element (14), has a first angle to a predetermined axis, and wherein the lens element (14), at a second surface portion, at which a straight line from a centre of the second light emitter, which is perpendicular to a plane of the second emitter, intersects an outer surface of the lens element (14), has a second angle to a predetermined axis, and wherein an angle of at least ½ degree exists between the first and second angles.

7. A light emitting assembly (10) according to any of the preceding claims, wherein a first surface portion of the lens element (14), at which a straight line from a centre of the first light emitter, which is perpendicular to a plane of the first emitter, intersects an outer surface of the lens element (14), defines a first normal direction, and wherein a second surface portion of the lens element (14), at which a straight line from a centre of the second light emitter, which is perpendicular to a plane of the second emitter, intersects an outer surface of the lens element (14), defines a second normal direction, wherein an angle of at least 1 degree exists between the first and second normal directions.

8. A light emitting assembly (10) according to any of the claims 1-3 and 5-7, wherein a total refractive index within the lens is different along the two paths taken by beams of the first and second light emitter.

9. A light emitting assembly (10) according to claim 8, wherein the refractive index varies only at an upper surface of the lens.

10. A light emitting assembly (10) according to claim 8, wherein beams of the first and second light emitters (122,124,126,128) take non-parallel paths in the lens, wherein the light emitters (122,124,126,128) are positioned so as to output parallel beams.

11. A vehicle comprising one or more light emitting assemblies, where a light emitting assembly (10) according to one of claims 1-10 is attached to a structural portion of the vehicle.

12. A vehicle according to claim 11, wherein the light emitting assembly (10) is attached to one of the group consisting of: a headrest, an armrest, a B pillar, a C pillar, a parcel shelf, or a door.

13. A method of operating a light emitting assembly (10) for vehicle interior lighting, wherein the light emitting assembly (10) is according to one of the claims 1-10, the method comprising, during a first period of time, increasing an intensity of light output a by first light emitter and decreasing an intensity of light output by a second light emitter, wherein the emitted light of the first and second light emitters (122,124,126,128) produces a pattern in a passenger compartment of the vehicle, and by varying the intensity of the light emitters (122,124,126,128), the pattern is moved slightly,
wherein the light emitting assembly (10) is attached to a structural portion of a vehicle,
wherein the structural portion is one of the group consisting of a headrest, an armrest, a B pillar, a C pillar, a parcel shelf, or a door,
wherein the assembly emits light toward a ceiling or side portions of the vehicle in the passenger compartment thereof.

14. A method according to claim 13, further comprising the step of, during a subsequent period of time, decreasing the intensity of the light output by the first light emitter and increasing an intensity of light output by the second or a third light emitter.

15. A method according to claim 13 or 14, wherein the combined intensity of light output by the light emitters (122,124,126,128) is controlled to be within a predetermined intensity interval.

## Patentansprüche

1. Lichtemittierende Anordnung (10) zur Fahrzeuginnenraumbeleuchtung, umfassend:
ein lichtemittierendes Element (12), umfassend zwei oder mehr individuell steuerbare Lichtemitter (122, 124, 126, 128),
eine Steuerung zum Steuern der lichtemittierenden Anordnung,
ein Linsenelement (14), das so positioniert ist, dass es von den Lichtemittern (122, 124, 126, 128) emittiertes Licht sammelt und
ausgibt, wobei das Linsenelement (14) zu Folgendem konfiguriert ist:
Emittieren von Licht von einem Mittelpunkt eines ersten Lichtemitters in eine erste Richtung und
Emittieren von Licht von einem Mittelpunkt eines zweiten Lichtemitters in eine zweite Richtung, wobei die erste und zweite Richtung mindestens einen Winkel von 1 Grad zwischen einander aufweisen,
wobei die lichtemittierende Anordnung so konfiguriert ist, dass sie an einem Konstruktionsabschnitt eines Fahrzeugs angebracht ist,
wobei der Konstruktionsabschnitt eines von der Gruppe, bestehend aus einer Kopfstütze, einer Armstütze, einer B-Säule, einer C-Säule, einer Hutablage oder einer Tür, ist,
wobei die Anordnung so konfiguriert ist, dass sie Licht in Richtung einer Decke oder von Seitenabschnitten des Fahrzeugs in einer Fahrgastzelle davon emittiert,
**dadurch gekennzeichnet, dass** die Lichtemitter (122,124,126,128) so konfiguriert sind, dass sie Licht mit unterschiedlichen Farben emittieren, wobei das emittierte Licht des ersten und zweiten Lichtemitters (122,124,126,128) ein Muster in der Fahrgastzelle des Fahrzeugs erzeugt, und durch Variieren der Intensität der Lichtemitter (122,124,126,128), sodass während einer Zeitspanne eine Intensität der Lichtausgabe eines ersten Lichtemitters erhöht wird und eine Intensität der Lichtabgabe eines zweiten Lichtemitters verringert wird, das Muster geringfügig bewegt wird.

2. Lichtemittierende Anordnung (10) nach Anspruch 1, wobei die Mittelpunkte des ersten und zweiten Lichtemitters (122, 124, 126, 128) mindestens 200 µm voneinander entfernt positioniert sind.

3. Lichtemittierende Anordnung (10) nach einem der vorhergehenden Ansprüche, wobei der erste und zweite Lichtemitter (122, 124, 126, 128) eben und in einer gemeinsamen Ebene bereitgestellt sind.

4. Lichtemittierende Anordnung (10) nach Anspruch 1 oder 2, wobei der erste und zweite Lichtemitter (122, 124, 126, 128) eben und mit einem Winkel zueinander von mindestens ½ Grad bereitgestellt sind.

5. Lichtemittierende Anordnung (10) nach einem der vorhergehenden Ansprüche, wobei die Illumination, die von dem ersten und zweiten Emitter bereitgestellt ist, ohne bewegliche Teile variiert.

6. Lichtemittierende Anordnung (10) nach einem der vorhergehenden Ansprüche, wobei das Linsenelement (14) an einem ersten Oberflächenabschnitt, an dem eine Gerade von einem Mittelpunkt des ersten Lichtemitters, die senkrecht zu einer Ebene des ersten Emitters ist, eine äußere Oberfläche des Linsenelements (14) schneidet, einen ersten Winkel zu einer vorbestimmten Achse aufweist und wobei das Linsenelement (14) an einem zweiten Oberflächenabschnitt, an dem eine Gerade von einem Mittelpunkt des zweiten Lichtemitters, die senkrecht zu einer Ebene des zweiten Emitters ist, eine äußere Oberfläche des Linsenelements (14) schneidet, einen zweiten Winkel zu einer vorbestimmten Achse aufweist und wobei zwischen dem ersten und zweiten Winkel ein Winkel von mindestens ½ Grad besteht.

7. Lichtemittierende Anordnung (10) nach einem der vorhergehenden Ansprüche, wobei ein erster Oberflächenabschnitt des Linsenelements (14), an dem eine Gerade von einem Mittelpunkt des ersten Lichtemitters, die senkrecht zu einer Ebene des ersten Emitters ist, eine äußere Oberfläche des Linsenelements (14) schneidet, eine erste nominale Richtung definiert und wobei ein zweiter Oberflächenabschnitt des Linsenelements (14), an dem eine Gerade von einem Mittelpunkt des zweiten Lichtemitters, die senkrecht zu einer Ebene des zweiten Emitters ist, eine äußere Oberfläche des Linsenelements (14) schneidet, eine zweite nominale Richtung definiert, wobei zwischen der ersten und zweiten nominalen Richtung ein Winkel von mindestens 1 Grad besteht.

8. Lichtemittierende Anordnung (10) nach einem der Ansprüche 1 bis 3 und 5 bis 7, wobei ein Gesamtbrechungsindex innerhalb der Linse entlang der zwei Verläufe, die von Strahlen des ersten und zweiten Lichtemitters genommen werden, unterschiedlich ist.

9. Lichtemittierende Anordnung (10) nach Anspruch 8, wobei der Brechungsindex nur an einer oberen Oberfläche der Linse variiert.

10. Lichtemittierende Anordnung (10) nach Anspruch 8, wobei Strahlen des ersten und zweiten Lichtemitters (122, 124, 126, 128) nicht parallele Verläufe in der Linse nehmen, wobei die Lichtemitter (122, 124, 126, 128) so positioniert sind, dass sie parallele Strahlen ausgeben.

11. Fahrzeug, umfassend eine oder mehrere lichtemittierende Anordnungen, wobei eine lichtemittierende Anordnung (10) nach einem der Ansprüche 1 bis 10 an einem Konstruktionsabschnitt des Fahrzeugs angebracht ist.

12. Fahrzeug nach Anspruch 11, wobei die lichtemittierende Anordnung (10) an einem von der Gruppe angebracht ist, bestehend aus: einer Kopfstütze, einer Armstütze, einer B-Säule, einer C-Säule, einer Hutablage oder einer Tür.

13. Verfahren des Betreibens einer lichtemittierenden Anordnung (10) zur Fahrzeuginnenraumbeleuchtung, wobei die lichtemittierende Anordnung (10) nach einem der Ansprüche 1 bis 10 ist, wobei das Verfahren während einer ersten Zeitspanne ein Erhöhen einer Intensität einer Lichtausgabe eines ersten Lichtemitters und ein Verringern einer Intensität einer Lichtausgabe eines zweiten Lichtemitters umfasst, wobei das emittierte Licht des ersten und zweiten Lichtemitters (122, 124, 126, 128) ein Muster in einer Fahrgastzelle des Fahrzeugs erzeugt und durch Variieren der Intensität der Lichtemitter (122,124,126,128) das Muster geringfügig bewegt wird,
wobei die lichtemittierende Anordnung (10) an einem Konstruktionsabschnitt eines Fahrzeugs angebracht ist,
wobei der Konstruktionsabschnitt eines von der Gruppe, bestehend aus einer Kopfstütze, einer Armstütze, einer B-Säule, einer C-Säule, einer Hutablage oder einer Tür, ist,
wobei die Anordnung Licht in Richtung einer Decke oder von Seitenabschnitten des Fahrzeugs in der Fahrgastzelle davon emittiert.

14. Verfahren nach Anspruch 13, ferner umfassend den Schritt des Verringerns der Intensität des von dem ersten Lichtemitter ausgegebenen Lichts und Erhöhens einer Intensität des von dem zweiten oder einem dritten Lichtemitter ausgegebenen Lichts während einer nachfolgenden Zeitspanne.

15. Verfahren nach Anspruch 13 oder 14, wobei die kombinierte Intensität des von den Lichtemittern (122, 124, 126, 128) ausgegebenen Lichts so gesteuert wird, dass sie innerhalb eines vorbestimmten Intensitätsintervalls ist.

## Revendications

1. Assemblage électroluminescent (10) pour l'éclairage intérieur d'un véhicule comprenant :
- un élément électroluminescent (12) comprenant au moins deux émetteurs de lumière commandables individuellement (122, 124, 126, 128),
- un dispositif de commande pour commander l'assemblage électroluminescent,
- un élément de lentille (14) positionné de manière à collecter et à délivrer la lumière émise par les émetteurs de lumière (122, 124, 126, 128), l'élément de lentille (14) étant configuré pour :
- émettre de la lumière à partir d'un centre d'un premier émetteur de lumière dans une première direction et
- émettre de la lumière à partir d'un centre d'un deuxième émetteur de lumière dans une seconde direction, les première et seconde directions formant entre elles un angle d'au moins 1 degré,
dans lequel l'assemblage électroluminescent est configuré pour être fixé à une partie structurelle d'un véhicule,
dans lequel la partie structurelle fait partie du groupe constitué d'un appui-tête, d'un accoudoir, d'un montant B, d'un montant C, d'une plage arrière, ou d'une porte,
dans lequel l'assemblage est configuré pour émettre de la lumière vers un plafond ou des parties latérales du véhicule dans un habitacle de celui-ci,
**caractérisé en ce que** les émetteurs de lumière (122, 124, 126, 128) sont configurés pour émettre de la lumière de différentes couleurs, dans lequel la lumière émise par les premier et deuxième émetteurs de lumière (122, 124, 126, 128) produit un motif dans l'habitacle du véhicule, et en faisant varier l'intensité des émetteurs de lumière (122, 124, 126, 128), de sorte que, pendant une période de temps, une intensité lumineuse de sortie d'un premier émetteur de lumière est augmentée et une intensité lumineuse de sortie d'un deuxième émetteur de lumière est diminuée, le motif est légèrement déplacé.

2. Assemblage électroluminescent (10) selon la revendication 1, dans lequel les centres des premier et deuxième émetteurs de lumière (122, 124, 126, 128) sont positionnés à au moins 200 µm l'un de l'autre.

3. Assemblage électroluminescent (10) selon l'une quelconque des revendications précédentes, dans lequel les premier et deuxième émetteurs de lumière (122, 124, 126, 128) sont plans et disposés dans un plan commun.

4. Assemblage électroluminescent (10) selon la revendication 1 ou 2, dans lequel les premier et deuxième émetteurs de lumière (122, 124, 126, 128) sont plans et disposés selon un angle d'au moins ½ degré l'un par rapport à l'autre.

5. Assemblage électroluminescent (10) selon l'une quelconque des revendications précédentes, dans lequel l'éclairage fourni par les premier et deuxième émetteurs varie sans aucune pièce mobile.

6. Assemblage électroluminescent (10) selon l'une quelconque des revendications précédentes, dans lequel l'élément de lentille (14), au niveau d'une première partie de surface, au niveau de laquelle une ligne droite partant d'un centre du premier émetteur de lumière, qui est perpendiculaire à un plan du premier émetteur, coupe une surface extérieure de l'élément de lentille (14), présente un premier angle par rapport à un axe prédéterminé, et dans lequel l'élément de lentille (14), au niveau d'une seconde partie de surface, au niveau de laquelle une ligne droite partant d'un centre du deuxième émetteur de lumière, qui est perpendiculaire à un plan du deuxième émetteur, coupe une surface extérieure de l'élément de lentille (14), présente un second angle par rapport à un axe prédéterminé, et dans lequel un angle d'au moins ½ degré existe entre les premier et second angles.

7. Assemblage électroluminescent (10) selon l'une quelconque des revendications précédentes, dans lequel une première partie de surface de l'élément de lentille (14), au niveau de laquelle une ligne droite partant d'un centre du premier émetteur de lumière, qui est perpendiculaire à un plan du premier émetteur, coupe une surface extérieure de l'élément de lentille (14), définit une première direction normale, et dans lequel une seconde partie de surface de l'élément de lentille (14), au niveau de laquelle une ligne droite partant d'un centre du deuxième émetteur de lumière, qui est perpendiculaire à un plan du deuxième émetteur, coupe une surface extérieure de l'élément de lentille (14), définit une seconde direction normale, dans lequel un angle d'au moins 1 degré existe entre les première et seconde directions normales.

8. Assemblage électroluminescent (10) selon l'une quelconque des revendications 1 à 3 et 5 à 7, dans lequel un indice de réfraction total à l'intérieur de la lentille est différent le long des deux trajets empruntés par les faisceaux du premier et du deuxième émetteur de lumière.

9. Assemblage électroluminescent (10) selon la revendication 8, dans lequel l'indice de réfraction varie uniquement sur une surface supérieure de la lentille.

10. Assemblage électroluminescent (10) selon la revendication 8, dans lequel des faisceaux des premier et deuxième émetteurs de lumière (122, 124, 126, 128) empruntent des trajets non parallèles dans la lentille, dans lequel les émetteurs de lumière (122, 124, 126, 128) sont positionnés de manière à délivrer des faisceaux parallèles.

11. Véhicule comprenant un ou plusieurs assemblages électroluminescents, dans lequel un assemblage électroluminescent (10) selon l'une des revendications 1 à 10 est fixé à une partie structurelle du véhicule.

12. Véhicule selon la revendication 11, dans lequel l'assemblage électroluminescent (10) est fixé à l'un des éléments du groupe constitué : d'un appui-tête, d'un accoudoir, d'un montant B, d'un montant C, d'une plage arrière, ou d'une porte.

13. Procédé de contrôle d'un assemblage électroluminescent (10) pour l'éclairage intérieur d'un véhicule, dans lequel l'assemblage électroluminescent (10) est selon l'une des revendications 1 à 10, le procédé comprenant, pendant une première période de temps, l'augmentation d'une intensité lumineuse délivrée par un premier émetteur de lumière et la diminution d'une intensité lumineuse délivrée par un deuxième émetteur de lumière, dans lequel la lumière délivrée par les premier et deuxième émetteurs de lumière (122, 124, 126, 128) produit un motif dans l'habitacle du véhicule, et en faisant varier l'intensité des émetteurs de lumière (122, 124, 126, 128), le motif est légèrement déplacé,
dans lequel l'assemblage électroluminescent (10) est fixé à une partie structurelle d'un véhicule,
dans lequel la partie structurelle fait partie du groupe constitué d'un appui-tête, d'un accoudoir, d'un montant B, d'un montant C, d'une plage arrière, ou d'une porte,
dans lequel l'assemblage émet de la lumière vers un plafond ou des parties latérales du véhicule dans l'habitacle de celui-ci.

14. Procédé selon la revendication 13, comprenant également l'étape consistant, pendant une période de temps ultérieure, à diminuer l'intensité de la lumière délivrée par le premier émetteur de lumière et à augmenter une intensité de la lumière délivrée par le deuxième ou un troisième émetteur de lumière.

15. Procédé selon la revendication 13 ou 14, dans lequel l'intensité combinée de la lumière délivrée par les émetteurs de lumière (122, 124, 126, 128) est commandée pour être dans un intervalle d'intensité prédéterminé.
